# EUROPEAN PATENT APPLICATION

(11) **EP 1 075 012 A2**
(43) Date of publication of application: **07.02.2001**
(21) Application number: 00115428.5
(22) Date of filing: 17.07.2000
(51) Int. Cl.: H01H 85/044

(54) **Fuse device**

(30) Priority: 06.08.1999 JP 22343999
(71) Applicant: TOYOTA JIDOSHA KABUSHIKI KAISHA, Aichi-ken 471-8571 (JP); Pacific Engineering Corporation, Ogaki-shi, Gifu-ken (JP)
(72) Inventor: Ogawa, Takashi, c/o Toyota Jidosha K.K., Aichi-ken, 471-8571 (JP); Ohta, Manabu, c/o Pacific Engineering Corp., Ogaki-shi, Gifu-ken (JP)
(74) Representative: Kuhnen & Wacker

(57) **Abstract**

In a fuse device (20), a circuit plate (30),formed by stamping a copper alloy plate, having two bus bar circuits (31, 32) that are interconnected by a blowout portion(33), a battery-connecting terminal (34), and load-connecting terminals (37, 39) connected to the bus bar circuits (31, 32). The circuit plate (30) is housed in a case (22) formed from an electrically insulating material. The battery-connecting terminal (34) is bent into an approximately 90* angle. The battery- connecting terminal (34) is connected to an output terminal of a battery, and also serves as a member for attaching the fuse device (20) to the battery. The bus bar circuits (31, 32) are formed together with a fuse circuit (33, 36, 38) formed by blowout portions, so that there is no danger of a contact failure caused by a defect in the connections between the bus bar circuits (31, 32) and the fuse circuit (33, 36, 38). The circuit plate (30) is simply housed in the case (22), so that the device (20) size can be reduced.

## Description

### BACKGROUND OF THE INVENTION

### 1. Field of the Invention

The present invention relates to a fuse device and, more particularly, to a fuse device that is disposed between a power source and an electric load that prevents overcurrent or overvoltage being applied to the load.

### 2. Description of the Related Art

A related fuse device incorporating a fuse circuit having a plurality of blowout portions formed by stamping a metal plate has been proposed by Japanese Utility Model Registration No. 2565750 . In this device, the fuse circuit is housed in a card-like case formed from an electrically insulating material. By inserting the case into a device body in a predetermined direction, terminals formed in the fuse circuit are electrically connected to connecting terminals of a bus bar circuit mounted in the device body. Since the fuse circuit is housed in the card-like case insertable into the device body, the fuse device facilitates replacement of the fuse circuit separately. However, since the bus bar and the fuse circuit are provided as separate units, there is a danger of a contact failure between the bus bar and the fuse circuit caused by a mounting defect of the fuse circuit or the like. Furthermore, since the fuse circuit is housed in a case formed from an electrically insulating material and is inserted into the device body, the fuse device is increased in size.

### SUMMARY OF THE INVENTION

Accordingly, it is an object of this invention to provide a fuse device that prevents a contact failure due to a mounting defect or the like. It is another object of this invention to reduce the size of the fuse device and to facilitate connection of the fuse device directly to a battery. It is a further object to facilitate connection of the fuse device to an electric load and in a way that prevents a connection failure.

In accordance with this invention, a fuse device is provided between a power source and a load for preventing an overcurrent or an overvoltage from being applied to the load. It includes a circuit plate in which a bus bar circuit and a fuse circuit having a fuse element are formed together.

Since the bus bar circuit and the fuse circuit are formed together in the fuse device of the invention, there is no danger of a contact failure between the bus bar circuit and the fuse circuit and there is no need to connect the circuits afterwards. Therefore, the reliability of the fuse device can be improved, and the assembly of the device becomes easy.

In the above described fuse device the fuse element may have a plurality of blowout portions. Therefore, the fuse device becomes applicable to a plurality of electric loads.

In this invention, the circuit plate may be formed from a copper alloy andmay have at least one connector-connecting terminal that is connectable to a connector at a side of the load.

The circuit plate may also have a power source-connecting terminal that is connected to a terminal provided at a side of the power source. Therefore, the fuse device can easily be connected to the power source. The power source-connecting terminal may be a terminal that is connected directly to a terminal of a battery.Therefore, it becomes unnecessary to employ a separate member for attaching the fuse device to the battery.

The circuit plate of this invention may have at least two bus bar circuits that are interconnected by a blowout portion.

This invention may further include a case for housing the circuit plate, the case being formed from an electrically insulating material.

### BRIEF DESCRIPTION OF THE DRAWINGS

The foregoing and further objects, features and advantages of the present invention will become apparent from the following description of a preferred embodiment with reference to the accompanying drawings, wherein like numerals are used to represent like elements and wherein:
FIGURE 1 is an external view illustrating a fuse device 20 of an embodiment of the invention attached to a battery 50; and
FIGURE 2 is a schematic illustration of a construction of a circuit plate 30 provided in the fuse device 20 of the embodiment.

### DETAILED DESCRIPTION OF PREFERRED EMBODIMENT

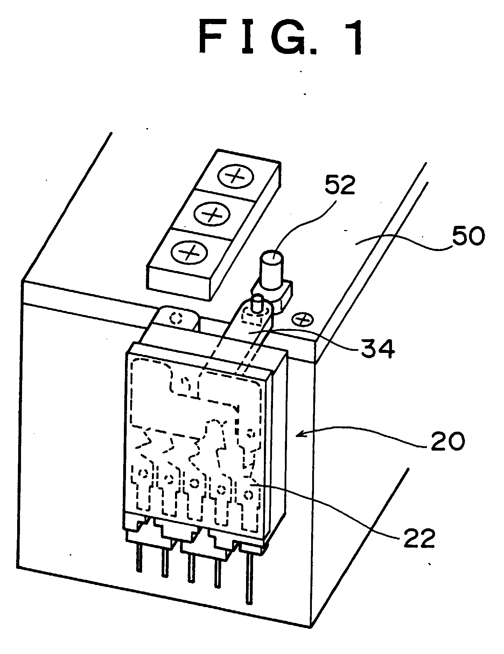

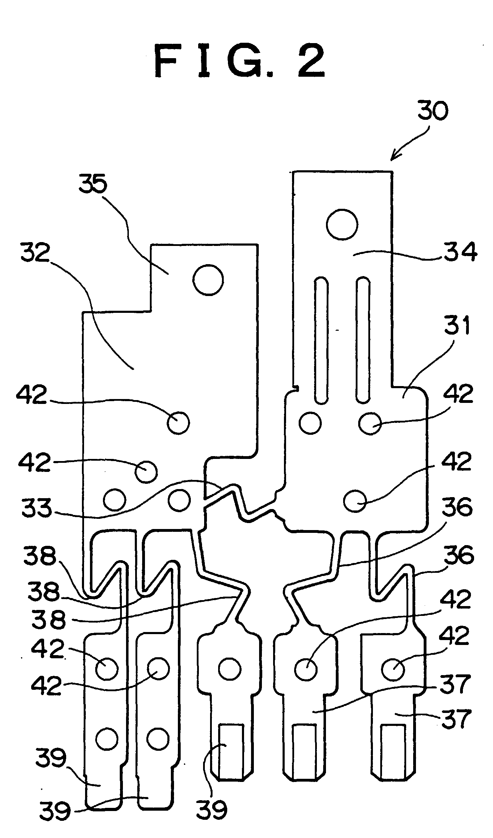

A preferred embodiment of the invention will be described hereinafter with reference to the accompanying drawings. FIGURE 1 is an external view illustrating a fuse device 20 according to the embodiment of the invention attached to a battery 50. FIGURE 2 is a schematic illustration of a construction of a circuit plate 30 provided in the fuse device 20 of the embodiment. The fuse device 20 of this embodiment includes a case 22 formed from an electrically insulating material, and the circuit plate 30 housed in the case 22. The fuse device 20 is attached directly to the battery 50.

The circuit plate 30 is formed by stamping a plate of a copper alloy made of copper and other metals (e.g. , iron, zinc, etc.) . As shown in FIGURE 2, the circuit plate 30 is provided with two bus bar circuits 31, 32 interconnected by a blowout portion 33, load-connecting connector terminals 37 connected to the bus bar circuit 31 by blowout portions 36, a connecting terminal 35 connected to the bus bar circuit 32, and load-connecting connector terminals 39 connected to the bus bar circuit 32 by blowout portions 38. Through-holes 42 for mounting the circuit plate 30 to the case 22 are formed at various sites in the bus bar circuit 32, so that the bus bar circuit 32 can be attached to the case 22 by bolts or resin.

A battery-connecting terminal 34 formed in the bus bar circuit 31 is bent into an approximately 90* angle as shown in FIGURE 1. The battery- connecting terminal 34 is connected to an output terminal 52 of the battery 50, and also serves as a member for attaching the fuse device 20 to the battery 50. That is, the fuse device 20 is attached to the battery 50 through the use of the battery-connecting terminal 34.

The connecting terminal 35 is used as a terminal that is connected to an alternator or the like if the battery 50 is installed in, for example, a vehicle. The load-connecting connector terminals 37 and the load-connecting connector terminals 39 are formed as male connector terminals, and can be connected directly to female terminals of electric loads.

Narrowest portions of the blowout portion 33, the blowout portions 36 and the blowout portions 38 are designed in accordance with the capacities of the loads or devices connected to the connecting terminal 35, the load-connecting connector terminals 37 and the load-connecting connector terminals 39, respectively, so that the narrowest portion of each blowout portion is blown out before an overcurrent or an overvoltage is applied to the corresponding load or device.

In the fuse device 20 of this embodiment, the bus bar circuit 31 and the bus bar circuit 32 are formed, as a single unit, together with a fuse circuit having the blowout portions 36 and the blowout portions 38. Therefore, the fuse device 20 eliminates the danger of a contact failure caused by a defect in the connection between the bus bar circuit and the fuse circuit. As a result, the reliability of the fuse device 20 is improved.

Furthermore, because the battery-connecting terminal 34 and the bus bar circuit 31 are formed together as a single unit in the fuse device 20, there is no danger of a contact failure between the bus bar circuit and the power source. Moreover, since the fuse device 20 can be attached to the battery 50 by means of the battery-connecting terminal 34, there is no need to employ a separate member for the attachment. Therefore, the number of component parts required is reduced, and the device construction can be simplified.

Still further, since the load-connecting connector terminals 37 and the load-connecting connector terminals 39 are also formed together as a single unit in the fuse device 20, the danger of a contact failure in the connections to electric loads or the like is reduced. Thus, the reliability of the fuse device 20 is further improved.

Because the bus bar circuit 31 and the bus bar circuit 32 are interconnected by the blowout portion 33 in the fuse device 20 of the embodiment, the loads or devices connected to the bus bar circuit 31 can be operated even if a problem occurs in the bus bar circuit 32.

Furthermore, since the fuse device 20 of the embodiment is formed simply by the case 22 and the circuit plate 30, the size of the device can be reduced.

Although in the fuse device 20 of the embodiment, the circuit plate 30 is formed from a copper alloy, the circuit plate 30 may be formed from other metals having good conductivity, for example, zinc, silver, etc.

Although the fuse device 20 of the embodiment is provided with the two bus bars 31, 32, the fuse device of the invention may have only one bus bar or more than two bus bars. Furthermore, the load-connecting connector terminals 37 and the load-connecting connector terminals 39 are formed as male connector terminals, these connector terminals may be formed as female terminals instead.

Although the fuse device 20 of the embodiment is attached to the battery 50 in the above description, the fuse device of the invention may also be attached to power sources other than a battery.

While the present invention has been described with reference to what are presently considered to be a preferred embodiment thereof, it is to be understood that the present invention is not limited to the disclosed embodiment or constructions. On the contrary, the present invention is intended to cover various modifications and equivalent arrangements.

## Claims

1. A fuse device (20) to be provided between a power source (50) and a load for preventing an overcurrent or an overvoltage from being applied to the load, the fuse device (20) characterized by comprising:
a circuit plate (30) including at least one bus bar circuit (31, 32) and at least one fuse circuit (33, 36, 38), the at least one fuse circuit (33, 36, 38) having a fuse element, the at least one bus bar circuit (31, 32) and the at least one fuse circuit (33, 36, 38) being integrally formed.

2. A fuse device according to claim 1, characterized in that the fuse element has a plurality of blowout portions (33, 36, 38).

3. A fuse device according to claim 1 or 2, characterized in that the circuit plate (30) is formed from a copper alloy.

4. A fuse device according to any one of claims 1-3, characterized in that the circuit plate (30) has at least one connector-connecting terminal (37, 39) that is connectable to a connector at a side of the load.

5. A fuse device according to any one of claims 1-4, characterized in that the circuit plate (30) has a power source-connecting terminal (34) that is connected to a terminal provided at a side of the power source.

6. A fuse device according to claim 5, characterized in that the power source-connecting terminal (34) is connected to a terminal of the battery and also serves as a member for attaching the fuse device to the battery.

7. A fuse device according to any one of claims 1-6, characterized in that the circuit plate (30) has at least two bus bar circuits (31, 32) that are interconnected by a blowout portion (33).

8. A fuse device according to any one of claims 1-7, characterized by further comprising a case (22) for housing the circuit plate (30), the case (20) being formed from an electrically insulating material.

9. A method of preventing an overcurrent or an overvoltage from being applied from a power source (50) to a load, the method characterized by comprising the step of disposing a fuse device (20) between the power source (50) and the load, wherein the fuse device (20) includes a circuit plate (30) including at least one bus bar circuit (31, 32) and at least one fuse circuit (33, 36, 38), the at least one fuse circuit (33, 36, 38) having a fuse element, the at least one bus bar circuit (31, 32) and the at least one fuse circuit (33, 36, 38) being integrally formed.

10. A method of manufacturing a fuse device (20) to be provided between a power source (50) and a load for preventing an overcurrent or an overvoltage from being applied to the load, the method characterized by comprising the step of: integrally forming a bus bar circuit (31, 32) and a fuse circuit (33, 36, 38) that have a fuse element.
